# EUROPÄISCHE PATENTANMELDUNG

(11) **EP 3 760 979 A1**
(43) Veröffentlichungstag der Anmeldung: **06.01.2021**
(21) Anmeldenummer: 20163653.7
(22) Anmeldetag: 17.03.2020
(51) Int. Cl.: G01D 5/244, G01D 3/08

(54) **POSITIONSMESSEINRICHTUNG UND VERFAHREN ZUM BETREIBEN EINER POSITIONSMESSEINRICHTUNG**

(30) Priorität: 01.07.2019 DE 102019209607
(71) Anmelder: Dr. Johannes Heidenhain GmbH, 83301 Traunreut (DE)
(72) Erfinder: OCHSENBRÜCHER, Ralf, 83355 Grabenstätt (DE); MAYER, Elmar, 83365 Nußdorf (DE)

(57) **Zusammenfassung**

Die vorliegende Erfindung betrifft eine Positionsmesseinrichtung mit
• einem Teilungsträger (12), auf dem eine Messteilung (14) angeordnet ist,
• wenigstens einem Positionssensor (20) mit dem durch Abtastung der Messteilung (14) positionsabhängige Messsignale (PS) generierbar sind,
• einer Verarbeitungseinheit (30), mit der die positionsabhängigen Messsignale (PS) zu Positionssignalen (P) verarbeitbar sind und
• einer Schnittstelleneinheit (40) zur Kommunikation mit einer Folgeelektronik (100) über wenigstens einen Datenübertragungskanal (45),
wobei die Positionsmesseinrichtung (10) eine Überwachungseinheit (60) umfasst, der wenigstens eine Betriebsbedingung (Ta, I1, I2, VDD, HM) der Positionsmesseinrichtung (10) zuführbar ist und die eine Auswerteeinheit (62) umfasst, die in Abhängigkeit von der wenigstens einen Betriebsbedingung (Ta, I1, I2, VDD, HM) eine Komponenten-Ausfallrate (AR_K1, AR_K2) wenigstens einer zu überwachenden Komponente (50, 60) und hieraus eine aktuelle Betriebsausfallrate (AR_B) der Positionsmesseinrichtung (10) ermittelt. Weiter betrifft die Erfindung ein Verfahren zum Betreiben einer derartigen Positionsmesseinrichtung.

## Beschreibung

### GEBIET DER TECHNIK

Die vorliegende Erfindung betrifft eine Positionsmesseinrichtung nach Anspruch 1, sowie ein Verfahren zum Betreiben einer Positionsmesseinrichtung gemäß Anspruch 8.

### STAND DER TECHNIK

Positionsmesseinrichtungen werden in Maschinen und Anlagen der Automatisierungstechnik eingesetzt, beispielsweise in Werkzeugmaschinen oder Fertigungsrobotern. Sie dienen dazu, Positionen, bzw. Positionsänderungen von beweglichen Teilen zu messen. So messen Drehgeber oder Winkelmessgeräte rotatorische Bewegungen, beispielsweise von sich drehenden Wellen. Längenmessgeräte dagegen messen lineare Verschiebungen zueinander beweglich angeordneter Maschinenteile.

Von Maschinen und Anlagen wird gefordert, dass sie ein hohes Maß an Zuverlässigkeit aufweisen. Zuverlässigkeit bedeutet zum einen die fehlerfreie Funktion (Verfügbarkeit) und zum anderen funktionale Sicherheit, also die Fähigkeit, auftretende Funktionsstörungen sicher zu erkennen.

Die EP 2 273 238 A2 beschreibt eine Möglichkeit, die verbleibende Lebensdauer eines Positionsmessgeräts zu ermitteln. Hierzu werden Betriebsgrößen, die die Lebensdauer beeinflussen, für die Ermittlung der Restlebensdauer gewichtet mit einbezogen. Hierzu ist jedoch eine große Datenbasis notwendig, die häufig nicht zur Verfügung steht. Grund hierfür ist gerade die hohe Qualität der Messgeräte, weil dadurch nur eine unzureichende Anzahl von ausgefallenen Geräten untersucht werden kann. Auch sind die genauen Umstände, die zu einem Ausfall geführt haben, häufig unbekannt, bzw. nicht reproduzierbar, was eine Analyse von Ausfallursachen weiter erschwert. Außerdem werden Messgeräte oft ausgetauscht, bevor sie ausfallen (präventive Wartung).

Maßnahmen zur Erhöhung der funktionalen Sicherheit dienen dazu, auftretende Fehlfunktionen eines Messgerätes zu erkennen, so dass aus einem Defekt des Messgeräts resultierende Gefahrensituationen weitestgehend vermieden werden. In anderen Worten ausgedrückt dürfen auftretende Defekte weder Bedienpersonal, das sich in einem Gefahrenbereich der Maschine oder Anlage aufhält, in Gefahr bringen, noch materiellen Schaden anrichten.

Die verbleibende Wahrscheinlichkeit, dass trotz aller vorgesehenen Fehleraufdeckungsmaßnamen ein Defekt unentdeckt bleibt, wird durch einen sogenannten PFH-Wert ("Probability of a dangerous undetected Failure per Hour") angegeben. Bei Positionsmesseinrichtungen wird der PFH-Wert vom Hersteller üblicherweise mittels einer System-FMEDA bestimmt. Dabei werden Anwendungsbedingungen zugrunde gelegt, die auf typischen Anwendungsprofilen solcher Geräte basieren. Der PFH-Wert wird garantiert, solange die Positionsmesseinrichtung im Rahmen dieser Anwendungsbedingungen betrieben wird. Etwaige Abweichungen von den Anwendungsbedingungen im realen Einsatz der Positionsmesseinrichtung bleiben unberücksichtigt.

### ZUSAMMENFASSUNG DER ERFINDUNG

Es ist Aufgabe der Erfindung, eine Positionsmesseinrichtung zu schaffen, mit einer verbesserten Angabe der Ausfallwahrscheinlichkeit.

Diese Aufgabe wird gelöst durch eine Positionsmesseinrichtung nach Anspruch 1.

Es wird eine Positionsmesseinrichtung vorgeschlagen, mit
- einem Teilungsträger, auf dem eine Messteilung angeordnet ist,
- wenigstens einem Positionssensor mit dem durch Abtastung der Messteilung positionsabhängige Messsignale generierbar sind,
- einer Verarbeitungseinheit, mit der die positionsabhängigen Messsignale zu Positionssignalen verarbeitbar sind und
- einer Schnittstelleneinheit zur Kommunikation mit einer

Folgeelektronik über wenigstens einen Datenübertragungskanal, wobei die Positionsmesseinrichtung eine Überwachungseinheit umfasst, der wenigstens eine Betriebsbedingung der Positionsmesseinrichtung zuführbar ist und die eine Auswerteeinheit umfasst, die in Abhängigkeit von der wenigstens einen Betriebsbedingung eine Komponenten-Ausfallrate wenigstens einer zu überwachenden Komponente und hieraus eine aktuelle Betriebsausfallrate der Positionsmesseinrichtung ermittelt.

Weiter ist es Aufgabe der Erfindung, ein Verfahren anzugeben, das eine verbesserte Angabe der Ausfallwahrscheinlichkeit einer Positionsmesseinrichtung ermöglicht.

Diese Aufgabe wird gelöst durch ein Verfahren zum Betreiben einer Positionsmesseinrichtung nach Anspruch 8.

Hierzu wird ein Verfahren zum Betreiben einer Positionsmesseinrichtung vorgeschlagen, die
- einen Teilungsträger, auf dem eine Messteilung angeordnet ist,
- wenigstens einen Positionssensor mit dem durch Abtastung der Messteilung positionsabhängige Messsignale generiert werden,
- eine Verarbeitungseinheit, mit der die positionsabhängigen Messsignale zu Positionssignalen verarbeitet werden und
- eine Schnittstelleneinheit zur Kommunikation mit einer Folgeelektronik über wenigstens einen Datenübertragungskanal,
umfasst, wobei die Positionsmesseinrichtung weiter eine Überwachungseinheit umfasst, der wenigstens eine Betriebsbedingung der Positionsmesseinheit zugeführt wird und die eine Auswerteeinheit umfasst, die in Abhängigkeit von der wenigstens einen Betriebsbedingung eine Komponenten-Ausfallrate wenigstens einer zu überwachenden Komponente und hieraus eine aktuelle Betriebsausfallrate der Positionsmesseinrichtung ermittelt.

Weitere vorteilhafte Merkmale der vorliegenden Erfindung ergeben sich aus den von Anspruch 1, bzw. 8 abhängigen Ansprüchen, sowie aus Beschreibung vorteilhafter Ausführungsformen anhand der Figuren.

### KURZE BESCHREIBUNG DER ZEICHNUNGEN

Es zeigt
- Figur 1: ein Blockdiagramm einer erfindungsgemäßen Positionsmesseinrichtung,
- Figur 2: ein Blockdiagramm einer weiteren Ausführungsform einer erfindungsgemäßen Positionsmesseinrichtung,
- Figur 3: ein Blockdiagramm einer weiteren Ausführungsform einer erfindungsgemäßen Positionsmesseinrichtung und
- Figur 4: ein Blockdiagramm einer weiteren Ausführungsform einer erfindungsgemäßen Positionsmesseinrichtung.

### BESCHREIBUNG DER AUSFÜHRUNGSFORMEN

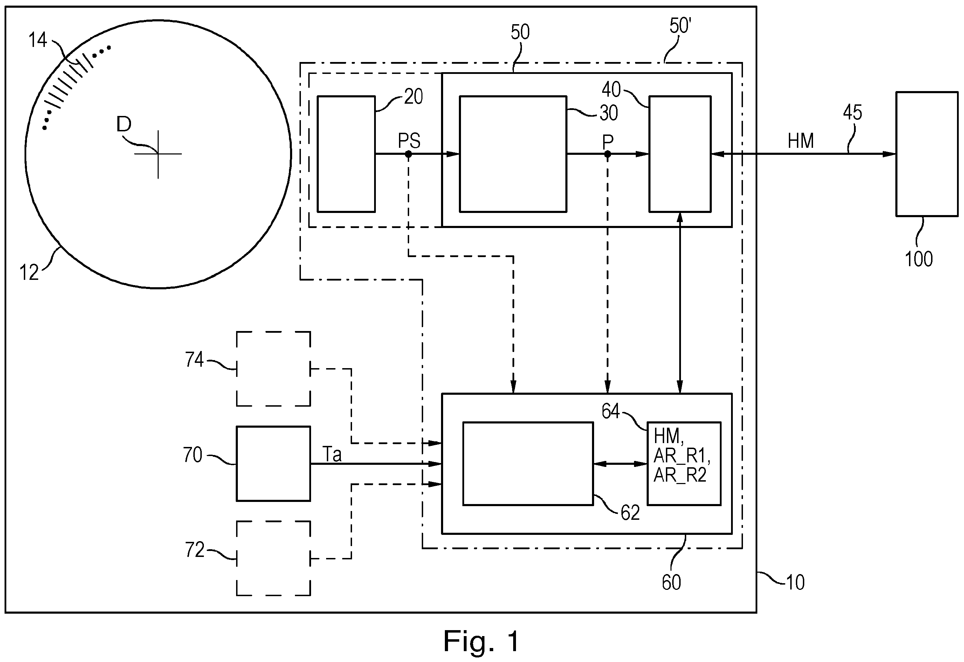

Figur 1 zeigt ein Blockdiagramm einer erfindungsgemäßen Positionsmesseinrichtung 10. Zur Messung, Verarbeitung und Ausgabe von positionsabhängigen Signalen umfasst die Positionsmesseinrichtung 10 einen Teilungsträger 12 mit einer Messteilung 14, wenigstens einen Positionssensor 20, eine Verarbeitungseinheit 30, sowie eine Schnittstelleneinheit 40.

Der Positionssensor 20 ist geeignet ausgestaltet, um die Messteilung 14 auf dem Teilungsträger 12 abzutasten. Teilungsträger 12 und Positionssensor 20 sind dabei in bekannter Weise in einer Messrichtung relativ zueinander beweglich angeordnet, beispielsweise indem sie mit beweglichen Teilen einer Werkzeugmaschine verbunden sind, deren Relativposition zueinander bestimmt werden soll. Positionssensor 20 und Messteilung 14 sind gemäß dem verwendeten physikalischen Abtastprinzip ausgestaltet, das bei der Positionsmessung zum Einsatz kommt.

Ob es sich bei der Positionsmesseinrichtung um ein Längenmessgerät oder, wie in Figur 1 dargestellt, um ein Winkelmessgerät (Drehgeber) handelt, ist für die vorliegende Erfindung nicht relevant. So kann es sich beim Teilungsträger 12 um einen geraden Maßstab mit einer in Maßstabsrichtung angeordneten Messteilung 14 zur Messung von linearen Bewegungen, oder um eine kreisrunde Scheibe mit einer radial um einen Scheibendrehpunkt D angeordneten Messteilung 14 zur Messung von Drehbewegungen, beispielsweise einer Welle, handeln.

Aus der Abtastung der Messteilung 14 resultieren positionsabhängige Positionssignale PS, die der Verarbeitungseinheit 30 zugeführt sind. Die Positionssignale PS können analoge, oder digital codierte Signale umfassen. Die Verarbeitungseinheit 30 verarbeitet die Positionssignale PS in digitale Positionswerte P und gibt sie an die Schnittstelleneinheit 40 aus. Auf die Verarbeitung wird hier nicht weiter eingegangen, es können Verarbeitungsschritte wie Signalkorrektur, Digitalisierung, etc. abgearbeitet werden. Neben den Positionswerten P können gegebenenfalls in der Verarbeitungseinheit 30 noch weitere positionsabhängige Größen ermittelt werden, beispielsweise Geschwindigkeit, Beschleunigung oder Ruck.

Die Schnittstelleneinheit 40 dient der Übertragung von Daten, beispielsweise der Positionswerte P, über einen Datenübertragungskanal 45 zu einer Folgeelektronik 100. Darüber hinaus kann die Übertragung von Befehlen und Daten von der Folgeelektronik 100 zur Schnittstelleneinheit 40 vorgesehen sein, so dass eine Kommunikation zwischen der Folgeelektronik 100 und der Schnittstelleneinheit 40 (und damit der Positionsmesseinrichtung 10) möglich ist. So kann die Folgeelektronik 100 mittels Datenanforderungsbefehlen Daten (z.B. einen aktuellen Positionswert P) von der Positionsmesseinrichtung 10 anfordern. Für die Datenübertragung zwischen der Folgeelektronik 100 und der Positionsmesseinrichtung 10 kommen bevorzugt serielle Schnittstellen zum Einsatz.

In der Positionsmesseinrichtung 10 ist wenigstens ein integrierter Schaltkreis (IC) vorgesehen. Im vorliegenden Ausführungsbeispiel umfasst ein integrierter Schaltkreis 50 die elektrische Schaltung der Verarbeitungseinheit 30 und der Schnittstelleneinheit 40. Bei dem integrierten Schaltkreis 50 kann es sich um eine anwendungsspezifische integrierte Schaltung (ASIC) oder eine programmierbare integrierte Schaltung (z.B. FPGA) handeln. Wie durch die gestrichelte Linie angedeutet, kann der integrierte Schaltkreis 50 darüber hinaus den Positionssensor 20 umfassen. Das ist insbesondere bei einem optischen Abtastprinzip vorteilhaft, da hier der Positionssensor Fotodetektoren umfasst, die mit bekannten Herstellungsverfahren auf einem Halbleiterchip hergestellt werden können. Integrierte Schaltungen, die sowohl optische Bauteile, als auch analoge und digitale Schaltungsteile umfassen, sind auch unter der Bezeichnung "Opto-ASIC" bekannt.

Jede funktionale Komponente der Positionsmesseinrichtung 10 weist eine Komponenten-Ausfallrate auf, die die Ausfallwahrscheinlichkeit der Komponente angibt. Die Komponenten-Ausfallrate wird üblicherweise in der Einheit FIT (Failure In Time) angegeben, wobei gilt: 1 FIT = 1x10⁻⁹/h. Sie ist eine variable Größe, die sich in Abhängigkeit von relevanten Betriebsbedingungen ändert. Relevante Betriebsbedingungen sind Betriebsbedingungen, die einen signifikanten Einfluss auf die Komponenten-Ausfallrate haben. Im vorliegenden Beispiel ist dem integrierten Schaltkreis 50 eine Komponenten-Ausfallrate AR_K1 zugeordnet.

Gemäß der vorliegenden Erfindung umfasst die Positionsmesseinrichtung 10 eine Überwachungseinheit 60. Die Überwachungseinheit 60 ist geeignet ausgestaltet um, abhängig von Betriebsbedingungen der Positionsmesseinrichtung 10, wenigstens eine Komponenten-Ausfallrate (die Ausfallrate einer zu überwachenden Systemkomponente in Abhängigkeit von wenigstens einer Betriebsbedingung) und daraus eine Betriebsausfallrate AR_B der Positionsmesseinrichtung 10 zu ermitteln. Im vorliegenden Beispiel wird die Komponenten-Ausfallrate AR_K1 des integrierten Schaltkreises 50 betrachtet.

Bei der Überwachungseinheit 60 kann es sich um einen eigenständigen integrierten Schaltkreis handeln, beispielsweise einen Mikrocontroller, einen programmierbaren Baustein (FPGA) oder einen applikationsspezifischen integrierten Schaltkreis (ASIC). Sie kann aber auch, wie durch die strichpunktierte Linie angedeutet, als Schaltungsmodul im integrierten Schaltkreis 50 integriert sein, so dass ein integrierter Schaltkreis 50' gebildet ist.

Die Betriebsbedingungen, die Einfluss auf Komponenten-Ausfallraten und damit auf die Betriebsausfallrate AR_B haben, können unterteilt werden in externe Betriebsbedingungen und interne Betriebsbedingungen. Externe Betriebsbedingungen werden außerhalb von der Positionsmesseinrichtung 10 erfasst oder festgelegt und können der Überwachungseinheit 60 über die Schnittstelleneinheit 40 zugeführt werden, beispielsweise von der Folgeelektronik 100.

Ein Beispiel für eine externe Betriebsbedingung ist eine Zeitinformation. Anhand der Zeitinformation, umfassend ein Datum und gegebenenfalls eine

Uhrzeit, kann das Alter der Positionsmesseinrichtung 10 und daraus ein altersbedingter Anteil der Betriebsausfallrate AR_B bestimmt werden. Dieser Anteil kann am Beginn der Lebensdauer der Positionsmesseinrichtung 10 einen etwas höheren Wert aufweisen, der dann auf ein niedriges Niveau sinkt und erst gegen Ende der Lebensdauer wieder ansteigt (Badewannenkurve).

Ein weiteres Beispiel für eine externe Betriebsbedingung ist die Einsatzhöhe über dem Meeresspiegel. Sie beeinflusst die sogenannte Soft-Error-Rate von integrierten Schaltkreisen, da mit steigender Höhe die Höhenstrahlung zunimmt. Das bedeutet, dass die Positionsmesseinrichtung 10 energiereicher Partikelstrahlung ausgesetzt wird, die insbesondere die Komponenten-Ausfallrate AR_K1 des integrierten Schaltkreises 50 erhöht, was sich wiederum ungünstig auf die Betriebsausfallrate AR_B auswirkt. Ein vergleichbarer Effekt kann auftreten, wenn die Positionsmesseinrichtung 10 im Umfeld einer Maschine betrieben wird, in der hochenergetische ionisierende Strahlung vorkommt, beispielsweise bei medizinischen Bestrahlungsapparaten.

Interne Betriebsbedingungen sind Betriebsbedingungen, die von der Positionsmesseinrichtung 10 selbst erfasst werden. Dazu zählen Betriebsbedingungen, die unmittelbar auf die Komponenten der Positionsmesseinrichtung 10 einwirken und deshalb mit Vorteil am Ort ihres Einstehens, bzw. Auftretens bestimmt werden. Für die Erfassung können Sensoren innerhalb eines Gehäuses der Positionsmesseinrichtung 10 angeordnet sein. Ein Beispiel für eine interne Betriebsbedingung ist die Temperatur. Sie hat insbesondere auf die Ausfallrate von integrierten Schaltkreisen einen großen Einfluss.

In diesem ersten Ausführungsbeispiel ist in der Positionsmesseinrichtung 10 ein Temperatursensor 70 vorgesehen. Er ist zusammen mit dem integrierten Schaltkreis 50 innerhalb eines Gehäuses der Positionsmesseinrichtung 10 angeordnet, beispielsweise auf einer Leiterplatte. Mit dem Temperatursensor 70 ist somit die Umgebungstemperatur Ta der in der Positionsmesseinrichtung 10 angeordneten Bauteile, insbesondere des integrierten Schaltkreises 50, messbar.

Neben dem Temperatursensor 70 können weitere Sensoren 72, 74 zur Ermittlung weiterer interner Betriebsbedingungen vorgesehen sein. Beispielsweise können die weiteren Sensoren 72, 74 Beschleunigungssensoren, Vibrationssensoren, Körperschallsensoren, Feuchtesensoren, Stromsensoren, Spannungssensoren, sowie Zeitsensoren (Betriebsstundenmesser) umfassen. Der Positionssensor 20, ggf. in Verbindung mit der Verarbeitungseinheit 30, kann ebenfalls als Sensor zu Bestimmung interner Betriebsbedingungen herangezogen werden, weil auch Positionen, bzw. Positionsänderungen (Geschwindigkeit, Beschleunigung) Einfluss auf die Betriebsausfallrate AR_B haben können. Die Messwerte der weiteren Sensoren 72, 74 sind ebenfalls der Auswerteeinheit 62 zugeführt und können zur Ermittlung der Komponenten-Ausfallrate AR_K1 und hieraus der Betriebsausfallrate AR_B herangezogen werden.

Für den Anschluss der Sensoren 20, 70, 72, 74 an der Überwachungseinheit 60 sind geeignete Schnittstellen vorgesehen. Je nachdem, ob es sich um analoge oder digitale Sensoren handelt, können A/D-Wandler oder digitale Datenschnittstellen zum Einsatz kommen, um der Auswerteeinheit 62 für die weitere Verarbeitung digitale Messwerte der zu erfassenden Betriebsbedingung zuzuführen.

In der Praxis wird die Betriebsausfallrate AR_B meist von Komponenten-Ausfallraten weniger Komponenten der Positionsmesseinrichtung 10 bestimmt. Das ist zum einen dann der Fall, wenn eine Komponente eine vergleichsweise hohe Komponenten-Ausfallrate aufweist und daher einen signifikanten Beitrag zur Betriebsausfallrate AR_B leistet, zum anderen wenn die Komponenten-Ausfallrate einer Komponente hohe Schwankungen unter dem Einfluss sich ändernder Betriebsbedingungen aufweist. Derartige Komponenten werden im Folgenden als zu überwachende Komponenten bezeichnet. Komponenten, die eine vergleichsweise niedrige Komponenten-Ausfallrate aufweisen und/oder bei denen die Komponenten-Ausfallrate bei sich ändernden Betriebsbedingungen weitgehend konstant ist, können bei der Ermittlung der Betriebsausfallrate AR_B gegebenenfalls vernachlässigt werden, bzw. ihr Beitrag zur Betriebsausfallrate AR_B als konstant angenommen werden.

Im vorliegenden Ausführungsbeispiel ist der integrierte Schaltkreis 50 die zu überwachende Komponente. Er weist eine Komponenten-Ausfallrate AR_K1 auf.

Die Bestimmung der Betriebsausfallrate AR_B sind in der Auswerteeinheit 62 folgende Schritte notwendig:
- Ermittlung relevanter Betriebsbedingungen
- Bestimmung der Komponenten-Ausfallrate AR_K1 wenigstens einer zu überwachenden Komponente
- Bestimmung der Betriebsausfallrate AR_B der Positionsmesseinrichtung 10 basierend auf den Komponenten-Ausfallraten AR_Kn

Eine Betriebsbedingung, die in diesem Beispiel betrachtet werden soll, ist die Sperrschichttemperatur des Halbleiterchips des integrierten Schaltkreises 50.

Ausgangspunkt für die Bestimmung der Komponenten-Ausfallrate AR_K1 ist eine Referenzausfallrate AR_R1 des integrierten Schaltkreises 50. Sie ist durch die Wafertechnologie (Strukturbreiten, Herstellungsprozesse, etc.) und Referenzbedingungen (in diesem Fall eine Referenztemperatur der Sperrschicht des Halbleiterchips) bestimmt. Bei der Referenzausfallrate AR_R1 handelt es sich um eine Herstellerangabe des integrierten Schaltkreises 50. Da sie weitgehend unabhängig von der internen elektrischen Schaltung des integrierten Schaltkreises 50 ist und somit für alle integrierten Schaltkreise gilt, die mit der gleichen Wafertechnologie hergestellt wurden, liegt der Referenzausfallrate AR_R1 eine sichere Datenbasis zugrunde. Eine Analyse der Fehlerursachen ausgefallener Geräte ist somit nicht mehr notwendig. Die Referenzausfallrate AR_R1 ist in einer Speichereinheit 64 gespeichert, die in der Überwachungseinheit 60 angeordnet ist. Eine Abweichung von der Referenztemperatur führt zu einer Veränderung der Komponenten-Ausfallrate AR_K1 des integrierten Schaltkreises 50, die durch das Gesetz des Arrhenius bestimmt ist. Bei bekannter Leistungsaufnahme des integrierten Bausteins 50 kann die Sperrschichttemperatur des Halbleiterchips des integrierten Schaltkreises 50 basierend auf der Umgebungstemperatur Ta, die mit dem Temperatursensor 70 ermittelbar ist, und dem thermischen Widerstand des Gehäuses des integrierten Schaltkreises 50 bestimmt werden.

Die Umgebungstemperatur Ta ist einer Auswerteeinheit 62 zugeführt, die in der Überwachungseinheit 60 angeordnet ist. Die Auswerteeinheit 62 ermittelt basierend auf der Umgebungstemperatur Ta, die Komponenten-Ausfallrate AR_K1 des integrierten Schaltkreises 50 und hieraus die Betriebsausfallrate AR_B der Positionsmesseinrichtung 10. Hierfür kann in der Speichereinheit 64 eine Tabelle mit Komponenten-Ausfallraten AR_K1 des integrierten Schaltkreises 50 in Abhängigkeit von der Umgebungstemperatur Ta gespeichert sein. Alternativ kann die Ermittlung der Komponenten-Ausfallrate AR_K1 des integrierten Schaltkreises 50 auch durch Berechnung erfolgen. Hierzu kann im Falle der Temperatur das Gesetz des Arrhenius angewendet werden, zur Ermittlung des Einflusses weiterer Betriebsbedingungen können geeignete alternative Rechenvorschriften verwendet werden.

Wie oben bereits erwähnt, können auch externe Betriebsbedingungen in die Ermittlung der Betriebsausfallrate AR_B einfließen. Im Beispiel von Figur 1 ist der Positionsmesseinrichtung 10 von der Folgeelektronik 100 die Betriebshöhe HM zugeführt, die die Höhe über dem Meeresspiegel angibt, auf der die Positionsmesseinrichtung 10 betrieben wird. Die Betriebshöhe HM wird von der Schnittstelleneinheit 40 zur Überwachungseinheit 60 weitergeleitet. In der Überwachungseinheit 60 bestimmt die Auswerteeinheit 62 die aus der Betriebshöhe HM resultierende Soft-Error-Rate SER (wiederum beispielsweise aus einer Tabelle in der Speichereinheit 64). Die Soft-Error-Rate SER kann ebenfalls in der Einheit FIT angegeben werden und wird in die Ermittlung der Komponenten-Ausfallrate AR_K1 mit einbezogen. Basierend auf der Komponenten-Ausfallrate AR_K1 (und ggf. weiteren Komponenten-Ausfallraten) ist von der Auswerteeinheit 62 dann die Betriebsausfallrate AR_B der Positionsmesseinrichtung 10 bestimmbar. Im einfachsten Fall können die einzelnen Komponenten-Ausfallraten addiert werden. Insbesondere dann, wenn es sich um Komponenten-Ausfallraten von elektronischen Bauteilen handelt, kann die Betriebsausfallrate AR_B durch eine Markow-Analyse bestimmt werden.

Die Betriebshöhe HM kann bereits werksseitig zur Positionsmesseinrichtung 10 übertragen und dort gespeichert werden. Das ist insbesondere dann sinnvoll, wenn der Einsatzort und damit die Betriebshöhe HM bereits bei der Bestellung der Positionsmesseinrichtung 10 bekannt ist. Dabei ist es vorteilhaft, dass der Wert der Betriebshöhe HM schreibgeschützt gespeichert wird, so dass eine Änderung dieses Wertes nur von qualifiziertem Fachpersonal vorgenommen werden kann.

Mit Vorteil ist der Wert der Betriebshöhe HM rücklesbar, das heißt, er kann über die Schnittstelleneinheit 40 zur Folgeelektronik 100 übertragen werden. Auf diese Weise kann dieser Wert in der Folgeelektronik 100 auf Richtigkeit überprüft werden.

Neben der Betriebshöhe HM können der Positionsmesseinrichtung 10 weitere externe Betriebsbedingungen zugeführt und bei der Ermittlung der Betriebsausfallrate AR_B berücksichtigt werden, beispielsweise eine Zeitinformation T (Datum und ggf. Uhrzeit).

Die Betriebsausfallrate AR_B der Positionsmesseinrichtung 10 kann vom Anwender dazu verwendet werden, um eine Gesamt-Ausfallrate der Maschine oder Anlage, in der die Positionsmesseinrichtung 10 integriert ist, zu bestimmen. Anhand von der Gesamt-Ausfallrate kann die Verfügbarkeit der Maschine oder Anlage beurteilt werden. Außerdem kann, basierend auf der Betriebsausfallrate AR_B in Verbindung mit Resultaten einer FMEDA, oder einer vergleichbaren Methode zur Analyse der Betriebssicherheit, ein sogenannter PFH-Wert der Positionsmesseinrichtung 10 bestimmt werden, der die funktionale Sicherheit der Positionsmesseinrichtung 10 wiedergibt. Hieraus ist ein Maß für die funktionale Sicherheit der gesamten Maschine oder Anlage ableitbar.

Die Ermittlung der Betriebsausfallrate AR_B kann kontinuierlich erfolgen oder durch einen entsprechenden Befehl der Folgeelektronik 100 gestartet werden. Die Übertragung des Ergebnisses zur Folgeelektronik 100 erfolgt dann über die Schnittstelleneinheit 40 und den Datenübertragungskanal 45.

Um dem Betreiber der Maschine oder Anlage, in der die Positionsmesseinrichtung 10 integriert ist, die Analyse der Ausfallrate der Maschine oder Anlage zu erleichtern, ist es vorteilhaft, seitens der Folgeelektronik 100 einen Startbefehl und einen Stoppbefehl vorzusehen, die eine kontinuierliche Ermittlung der Betriebsausfallrate AR_B starten, bzw. stoppen und die Auswerteeinheit 62 geeignet auszugestalten, eine maximale Betriebsausfallrate AR_B in dem durch den Start- und den Stoppbefehl bestimmten Zeitintervall zu bestimmen. Auf diese Weise kann überprüft werden, ob die Maschine oder Anlage in einem zu überwachenden Arbeitszyklus zu jeder Zeit das erforderliche Maß an Verfügbarkeit und funktionaler Sicherheit erreicht. Bei Über- bzw. Unterschreitung eines vorgegebenen Werts der Gesamt-Ausfallrate können dann entsprechende Maßnahmen ergriffen werden, um den Betrieb der Maschine oder Anlage bezüglich Arbeitsgeschwindigkeit und funktionaler Sicherheit zu optimieren.

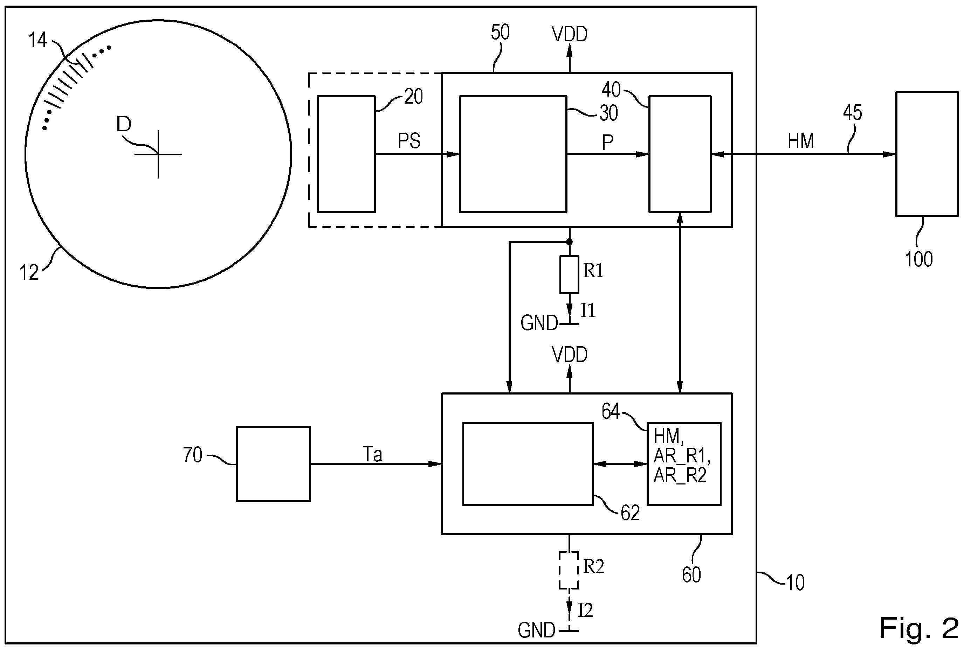

Figur 2 zeigt ein weiteres Ausführungsbeispiel einer erfindungsgemäßen Positionsmesseinrichtung 10. Komponenten, die bereits in Verbindung mit dem vorhergehenden Ausführungsbeispiel beschrieben wurden, tragen das gleiche Bezugszeichen. Dieses Beispiel zeigt eine verbesserte Möglichkeit, die Sperrschichttemperatur des Halbleiterchips des integrierten Schaltkreises 50 zu ermitteln. Da die Temperatur einen wesentlichen Einfluss auf die Komponenten-Ausfallrate AR_K1 hat, kann diese dadurch präziser bestimmt werden.

In diesem Ausführungsbeispiel wird, neben der Umgebungstemperatur Ta, die mit dem Temperatursensor 70 bestimmt wird, auch die aktuelle Leistungsaufnahme des integrierten Schaltkreises 50 berücksichtigt. Zusammen mit dem bekannten thermischen Widerstand des Gehäuses des integrierten Schaltkreises 50 kann dann die exakte Änderung der Sperrschichttemperatur des Halbleiterchips berechnet werden. In Verbindung mit der Umgebungstemperatur Ta kann dann dessen aktuelle Sperrschichttemperatur berechnet werden.

Zur Bestimmung der Leistungsaufnahme des integrierten Schaltkreises 50 ist nun ein Stromsensor, beispielsweise als Messwiderstand R1 ausgeführt, vorgesehen. Der Messwiderstand R1 ist in diesem Beispiel zwischen Massepotential GND der Stromversorgung der Positionsmesseinrichtung 10 und dem Masseanschluss des integrierten Schaltkreises 50 geschaltet. Der Spannungsabfall über den Messwiderstand R1 ist wiederum der Auswerteeinheit 62 als Sensorwert zugeführt. Anhand des Spannungsabfalls und des Wertes des Messwiderstands R1 kann nun in der Auswerteeinheit 62 der Betriebsstrom I1 des integrierten Schaltkreises 50 errechnet werden. Aus dem Betriebsstrom I1 und der bekannten Versorgungsspannung VDD des integrierten Schaltkreises 50 ergibt sich seine aktuelle Leistungsaufnahme, mit der, in Verbindung mit dem thermischen Widerstand des Gehäuses, schließlich eine Temperaturerhöhung des Halbleiterchips berechnet wird. Durch Addition der Umgebungstemperatur Ta ergibt sich dann die aktuelle Sperrschichttemperatur des Halbleiterchips. In weiterer Ausgestaltung des Verfahrens können auch Schwankungen der Versorgungsspannung VDD mit in die Berechnung einbezogen werden, indem ihr aktueller Wert in der Auswerteeinheit 62 gemessen wird. Hierzu kann eine Messleitung zwischen der Versorgungsspannung VDD und einem A/D-Wandler in der Auswerteeinheit 62 (nicht dargestellt) vorgesehen sein. Diese Messleitung kann als Spannungssensor im Sinne der vorliegenden Erfindung betrachtet werden.

Aus der aktuellen Sperrschichttemperatur des Halbleiterchips des integrierten Bausteins 50 bestimmt die Auswerteeinheit 62 (wiederum durch Berechnung oder aus einer Tabelle) die Komponenten-Ausfallrate AR_K1 des integrierten Bausteins 50 und hieraus die Betriebsausfallrate AR_B der Positionsmesseinrichtung 10.

Die Überwachungseinheit 60 weist selbst auch eine Komponenten-Ausfallrate AR_K2 auf, die die BetriebsausfallrateAR_B der Positionsmesseinrichtung 10 beeinflussen kann. Deshalb kann die Überwachungseinheit 60 selbst eine zu überwachende Komponente sein. Insbesondere dann, wenn die Überwachungseinheit 60 als integrierter Baustein ausgeführt ist, kann die Komponenten-Ausfallrate AR_K2 analog zur Komponenten-Ausfallrate AR_K1 des integrierten Bausteins 50 ermittelt werden, also basierend auf der Umgebungstemperatur Ta und ggf. des Betriebsstroms I2 (bestimmbar mittels eines Stromsensors R2) und der Versorgungsspannung VDD. Die Überwachungseinheit 60 ist also mit Vorteil ausgestaltet, die eigene Komponenten-Ausfallrate AR_K2 in Abhängigkeit relevanter Betriebsbedingungen (im der vorliegenden Ausführungsform der Umgebungstemperatur Ta und ggf. des Betriebsstroms I2 in Verbindung mit der Versorgungsspannung VDD) zu bestimmen und in die Ermittlung der Betriebsausfallrate AR_B der Positionsmesseinrichtung 10 einzubeziehen.

Zusammenfassend werden also zuerst als relevante Betriebsbedingungen die Umgebungstemperatur Ta, der Betriebsstrom I1 des integrierten Bausteins 50 und ggf. die Versorgungsspannung VDD des integrierten Bausteins 50 ermittelt. Anschließend wird seine aktuelle Komponenten-Ausfallrate AR_K1 bestimmt.

Wird auch die Überwachungseinheit 60 mit berücksichtigt, dann wird zusätzlich deren Betriebsstrom I2 und ggf. Versorgungsspannung VDD gemessen und die Komponenten-Ausfallrate AR_K2 bestimmt.

Aus den Komponenten-Ausfallraten AR_K1, AR_K2 wird schließlich die aktuelle Betriebsausfallrate AR_B ermittelt.

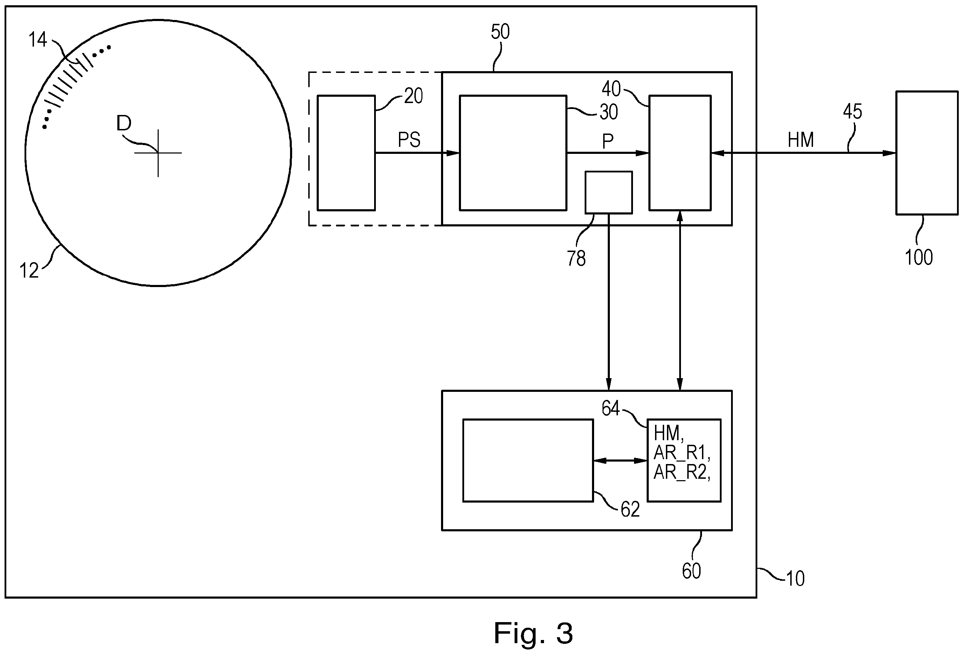

Figur 3 zeigt ein weiteres Ausführungsbeispiel einer erfindungsgemäßen Positionsmesseinrichtung 10. Komponenten, die bereits in Verbindung mit dem vorhergehenden Ausführungsbeispiel beschrieben wurden, tragen das gleiche Bezugszeichen. Dieses Beispiel zeigt eine alternative Möglichkeit, die Sperrschichttemperatur des Halbleiterchips des integrierten Schaltkreises 50 zu ermitteln.

Hier ist nun auf dem Halbleiterchip des integrierten Schaltkreises 50 ein On-Chip-Temperatursensor 78 mit integriert. Auf diese Weise ist die Sperrschichttemperatur des Halbleiterchips direkt messbar, die Messung ist somit genauer als die indirekte Bestimmung über den Umweg der Messung der Umgebungstemperatur, des Betriebsstroms und der Versorgungsspannung. Die Messung wird außerdem unabhängig vom tatsächlichen mechanischen Aufbau, insbesondere von der Ausführung eines Gehäuses (Material, Größe, etc.) des integrierten Schaltkreises 50.

Das Messsignal des On-Chip-Temperatursensors 78 ist der Auswerteeinheit 62 in der Überwachungseinheit 60 zur Bestimmung der Komponenten-Ausfallrate AR_K1 zugeführt.

Auch in diesem Ausführungsbeispiel können natürlich weitere Betriebsbedingungen erfasst, bzw. in die Ermittlung der Komponenten-Ausfallrate AR_K1 mit einbezogen werden.

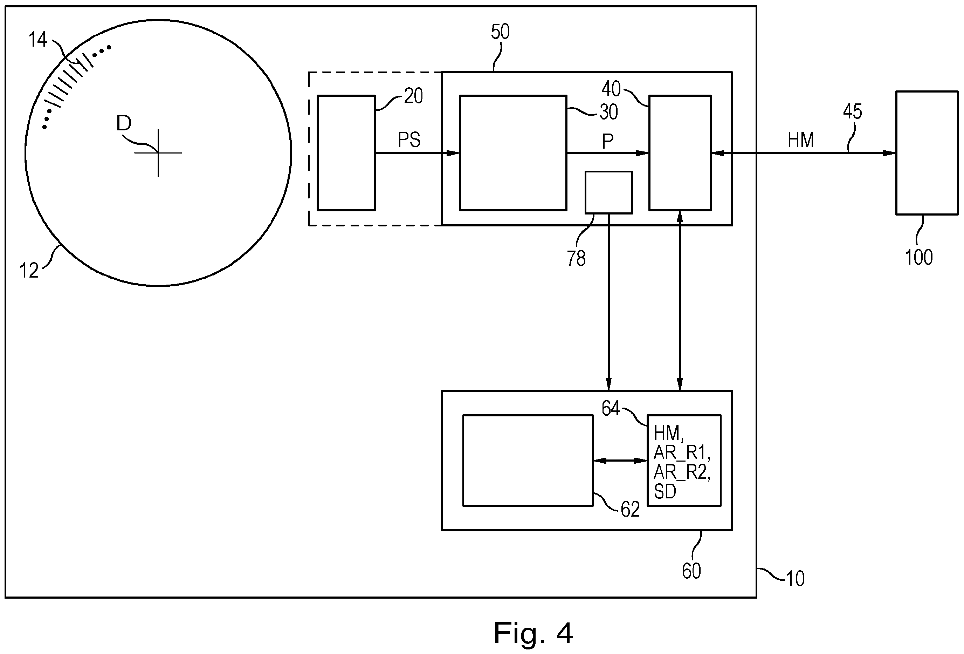

Figur 4 zeigt ein Blockdiagramm einer weiteren Ausführungsform einer erfindungsgemäßen Positionsmesseinrichtung 10. Auch hier tragen Funktionsblöcke, die bereits in Verbindung mit den vorhergehenden Ausführungsbeispielen beschrieben wurden, die gleichen Bezugszeichen.

Während in den vorhergehenden Ausführungsbeispielen davon ausgegangen wurde, dass erst in der Folgeelektronik 100 die funktionale Sicherheit der Positionsmesseinrichtung 10 bewertet wird, wird nun die Überwachungseinheit 60 dazu ertüchtigt, ein Maß für die funktionale Sicherheit der Positionsmesseinrichtung 10 in Form einer sicherheitsspezifischen Ausfallrate AR_S zu ermitteln. Hierzu sind in der Speichereinheit 64 Sicherheitsdaten SD der Positionsmesseinrichtung 10 gespeichert. Die Sicherheitsdaten SD werden herstellerseitig im Rahmen einer FMEDA, oder einer vergleichbaren Methode zur Überprüfung der funktionalen Sicherheit eines Gerätes, erfasst. Sie umfassen sowohl Informationen über Maßnahmen zur Erhöhung der funktionalen Sicherheit einzelner Komponenten (z.B. dem integrierten Schaltkreis 50), als auch über Maßnahmen, die durch das Zusammenwirken verschiedener Komponenten die funktionale Sicherheit erhöhen. Letzteres betrifft beispielsweise Überwachungsfunktionen für interne Signale (z.B. Taktsignale), sowie die Erzeugung von Redundanz durch parallele Signal- und Messpfade.

Die aus der Betriebsausfallrate AR_B ermittelte sicherheitsspezifische Ausfallrate AR_S entspricht dem aus der Sicherheitstechnik bekannten PFH-Wert der Positionsmesseinrichtung 10 und wird ebenfalls in der Einheit FIT (Failure In Time) angegeben, wobei gilt: 1 FIT = 1x10⁻⁹/h, was in diesem Fall bedeutet, dass ein gefährlicher, unaufdeckbarer Fehler je Milliarde Stunden auftreten kann. Sie ist ebenfalls über die Schnittstelleneinheit 40 zur Folgeelektronik 100 übertragbar. Dies erleichtert dem Betreiber der Maschine oder Anlage, in der die Positionsmesseinrichtung 10 betrieben wird, über die Verfügbarkeit hinaus, das aktuelle Maß für die funktionale Sicherheit zu einer Betriebssituation zu bestimmen, ohne weitere Informationen über die Positionsmesseinrichtung 10 diesbezüglich zu benötigen.

Die anhand der Figuren 1 und 2 beschriebenen Ausführungsbeispiele können selbstverständlich ebenfalls um die Ermittlung der sicherheitsspezifischen Ausfallrate AR_S erweitert werden.

Die vorliegende Erfindung ist nicht auf die beschriebenen Ausführungsbeispiele eingeschränkt. Vielmehr kann ein Fachmann alternative Ausführungen entwickeln, ohne den durch die Ansprüche definierten Schutzumfang zu verlassen.

## Patentansprüche

1. Positionsmesseinrichtung mit
• einem Teilungsträger (12), auf dem eine Messteilung (14) angeordnet ist,
• wenigstens einem Positionssensor (20) mit dem durch Abtastung der Messteilung (14) positionsabhängige Messsignale (PS) generierbar sind,
• einer Verarbeitungseinheit (30), mit der die positionsabhängigen Messsignale (PS) zu Positionssignalen (P) verarbeitbar sind und
• einer Schnittstelleneinheit (40) zur Kommunikation mit einer Folgeelektronik (100) über wenigstens einen Datenübertragungskanal (45),
wobei die Positionsmesseinrichtung (10) eine Überwachungseinheit (60) umfasst, der wenigstens eine Betriebsbedingung (Ta, I1, I2, VDD, HM) der Positionsmesseinheit zuführbar ist und die eine Auswerteeinheit (62) umfasst, die in Abhängigkeit von der wenigstens einen Betriebsbedingung (Ta, I1, I2, VDD, HM) eine Komponenten-Ausfallrate wenigstens einer zu überwachenden Komponente (50, 60) und hieraus eine aktuelle Betriebsausfallrate der Positionsmesseinrichtung ermittelt.

2. Positionsmesseinrichtung nach Anspruch 1, wobei in einer Speichereinheit (64) der Überwachungseinheit (60) Sicherheitsdaten (SD) speicherbar sind und in der Auswerteeinheit (62) mit Hilfe der Sicherheitsdaten (SD) aus der Betriebsausfallrate (AR_B) eine sicherheitsspezifische Ausfallrate (AR_S) ermittelbar ist, die ein Maß für die funktionale Sicherheit der Positionsmesseinrichtung (10) ist.

3. Positionsmesseinrichtung nach einem der vorhergehenden Ansprüche, wobei die Positionsmesseinrichtung wenigstens einen Sensor (70, 72, 74, 78, R1, R2) umfasst und der Messwert des Sensors (70, 72, 74, 78, R1, R2) der Überwachungseinheit (60) als Betriebsbedingung zuführbar ist und/oder der Überwachungseinheit (60) wenigstens eine Betriebsbedingung von der Folgeelektronik (100) über die Schnittstelleneinheit (40) zuführbar ist.

4. Positionsmesseinrichtung nach einem der vorhergehenden Ansprüche, wobei wenigstens eine zu überwachende Komponente (50, 60) ein integrierter Schaltkreis ist.

5. Positionsmesseinrichtung nach Anspruch 4, wobei in der Auswerteeinheit (62) die Komponenten-Ausfallrate (AR_K1) des integrierten Bausteins (50) basierend auf der Sperrschichttemperatur des Halbleiterchips ermittelbar ist, die mittels eines On-Chip-Temperatursensors (78) messbar ist, der auf dem Halbleiterchip integriert ist.

6. Positionsmesseinrichtung nach Anspruch 4, wobei in der Auswerteeinheit (62) die Komponenten-Ausfallrate (AR_K1) des integrierten Bausteins (50, 60) basierend auf der Sperrschichttemperatur des Halbleiterchips ermittelbar ist, die durch eine Umgebungstemperatur (Ta), seiner Leistungsaufnahme und dem thermischen Widerstand seines Gehäuses bestimmt ist und die Umgebungstemperatur (Ta) mittels eines Temperatursensors (70) messbar ist und die Leistungsaufnahme aus einem Betriebsstrom (I1) und einer Versorgungsspannung (VDD) des integrierten Bausteins (50, 60) berechenbar ist und zur Messung des Betriebsstroms (I1) ein Stromsensor (R1) vorgesehen ist.

7. Positionsmesseinrichtung nach Anspruch 6, wobei von der Auswerteeinheit (62) auch die Versorgungsspannung (VDD) des integrierten Bausteins (50, 60) messbar ist.

8. Verfahren zum Betreiben einer Positionsmesseinrichtung, umfassend
• einen Teilungsträger (12), auf dem eine Messteilung (14) angeordnet ist,
• wenigstens einen Positionssensor (20) mit dem durch Abtastung der Messteilung (14) positionsabhängige Messsignale (PS) generiert werden,
• eine Verarbeitungseinheit (30), mit der die positionsabhängigen Messsignale (PS) zu Positionssignalen (P) verarbeitet werden und
• eine Schnittstelleneinheit (40) zur Kommunikation mit einer Folgeelektronik (100) über wenigstens einen Datenübertragungskanal (45),
wobei die Positionsmesseinrichtung (10) eine Überwachungseinheit (60) umfasst, der wenigstens eine Betriebsbedingung (Ta, I1, I2, VDD, HM) der Positionsmesseinheit zugeführt wird und die eine Auswerteeinheit (62) umfasst, die in Abhängigkeit von der wenigstens einen Betriebsbedingung (Ta, I1, I2, VDD, HM) eine Komponenten-Ausfallrate wenigstens einer zu überwachenden Komponente (50, 60) und hieraus eine aktuelle Betriebsausfallrate der Positionsmesseinrichtung ermittelt.

9. Verfahren nach Anspruch 8, wobei in einer Speichereinheit (64) der Überwachungseinheit (60) Sicherheitsdaten (SD) gespeichert werden und in der Auswerteeinheit (62) mit Hilfe der Sicherheitsdaten (SD) aus der Betriebsausfallrate (AR_B) eine sicherheitsspezifische Ausfallrate (AR_S) ermittelt wird, die ein Maß für die funktionale Sicherheit der Positionsmesseinrichtung (10) ist.

10. Verfahren nach einem der Ansprüche 8 oder 9, wobei die Positionsmesseinrichtung wenigstens einen Sensor (70, 72, 74, 78, R1, R2) umfasst und der Messwert des Sensors (70, 72, 74, 78, R1, R2) der Überwachungseinheit (60) als Betriebsbedingung zugeführt wird und/oder der Überwachungseinheit (60) wenigstens eine Betriebsbedingung von der Folgeelektronik (100) über die Schnittstelleneinheit (40) zugeführt wird.

11. Verfahren nach einem der Ansprüche 8 bis 10, wobei wenigstens eine zu überwachende Komponente ein integrierter Schaltkreis (50) ist und in der Auswerteeinheit (62) die Komponenten-Ausfallrate (AR_K1) des integrierten Bausteins (50) basierend auf der Sperrschichttemperatur des Halbleiterchips ermittelt wird, die mittels eines On-Chip-Temperatursensors (78) gemessen wird, der auf dem Halbleiterchip integriert ist.

12. Verfahren nach einem der Ansprüche 8 bis 10, wobei wenigstens eine zu überwachende Komponente ein integrierter Schaltkreis (50, 60) ist und in der Auswerteeinheit (62) die Komponenten-Ausfallrate (AR_K1) des integrierten Bausteins (50) basierend auf der Sperrschichttemperatur des Halbleiterchips ermittelt wird, die durch eine Umgebungstemperatur (Ta), seiner Leistungsaufnahme und dem thermischen Widerstand seines Gehäuses bestimmt ist und die Umgebungstemperatur (Ta) mittels eines Temperatursensors (70) gemessen wird und die Leistungsaufnahme aus einem Betriebsstrom (I1) und einer Versorgungsspannung (VDD) des integrierten Bausteins (50, 60) berechnet wird und der Betriebsstrom (I1) mit einem Stromsensor (R1) gemessen wird.

13. Verfahren nach Anspruch 12, wobei von der Auswerteeinheit (62) auch die Versorgungsspannung (VDD) des integrierten Bausteins (50, 60) gemessen wird.

14. Verfahren nach einem der Ansprüche 8 bis 13, wobei von der Folgeelektronik durch einen Startbefehl und einen Stoppbefehl eine kontinuierliche Ermittlung der Betriebsausfallrate (AR_B) gestartet, bzw. gestoppt wird.

15. Verfahren nach Anspruch 14, wobei die Auswerteeinheit (62) in dem durch den Start- und den Stoppbefehl bestimmten Zeitintervall eine maximale Betriebsausfallrate bestimmt.
